# EUROPEAN PATENT SPECIFICATION

(11) **EP 0 794 098 B1**
(45) Date of publication and mention of the grant of the patent: **09.02.2000**
(21) Application number: 97103465.7
(22) Date of filing: 03.03.1997
(51) Int. Cl.: B61C 17/04, B61D 27/00

(54) **Electric power transforming apparatus for electric rolling stock**
Wandlereinrichtung für elektrische Energie für elektrische Schienenfahrzeuge
Dispositif de transformation de l'énérgie électrique pour véhicules ferroviaires électriques

(30) Priority: 05.03.1996 JP 4707096
(43) Date of publication of application: 10.09.1997
(73) Proprietor: Hitachi, Ltd., Chiyoda-ku, Tokyo 101 (JP); Hitachi Mito Engineering Co., Ltd., Hitachinaka-shi, Ibaraki-ken (JP); Hitachi Techno Engineering Co., Ltd., Adachi-ku, Tokyo (JP)
(72) Inventor: Suzuki, Osamu, Niihari-gun, Ibaraki-ken (JP); Tsuboi, Takashi, Hitachinaka-shi (JP); Itahana, Hiroshi, Hitachinaka-shi (JP); Mizuguchi, Nobuaki, Hitachinaka-shi (JP); Kato, Chisachi, Inashiki-gun, Ibaraki-ken (JP); Kuwahara, Heikichi, Tsuchiura-shi (JP); Kobayashi, Masanori, Abiko-shi (JP)
(74) Representative: Strehl Schübel-Hopf & Partner

(56) References cited:
- EP-A- 0 233 577
- EP-A- 0 397 557
- FR-A- 2 703 967
- JP-A- 6 163 770
- US-A- 5 285 347

## Description

### BACKGROUND OF THE INVENTION

### Field of the Invention

This invention relates to an electric power transforming apparatus which is to be used for a rolling stock, especially an electric rolling stock, and more particularly to a cooling system of the electric power transforming apparatus.

### Description of the Related Art

In an electric rolling stock, an electric power transforming apparatus for driving a motor at varying speed is usually installed under the floor of the rolling stock body. For instance, a controller of an inverter system comprises semiconductor switching elements (such as GTO, IGBT, for example), diodes, capacitors, resistors, gate controllers and the like. Since these component parts produce the heat loss at the time when the apparatus is operated, it is important to efficiently cool these parts. Particularly, the semiconductor switching elements generate a large quantity of heat, and therefore they are equipped with exclusive radiators. Such radiator is placed in an air duct communicating with the open air so as to be able to dissipate heat to the open air. Meanwhile, the diode, capacitor, gate controller and semiconductor switching element itself must be located in a clean atmosphere for making sure of reliability. For this purpose, it is effective to contain the component parts in an enclosed chamber lest they should be exposed to contaminated air outside a casing which houses the apparatus.

However, these electric devices contained in the enclosed chamber other than the semiconductor switching element also generate not a little heat, and therefore in order to keep down the temperature rise of the air in the enclosed chamber to a predetermined value or less, it is necessary to effect the heat exchange between the air in the enclosed chamber and the contaminated air outside the casing efficiently.

Japanese Patent Unexamined Publication No. 6-163770 (Document 1) discloses a cooling structure in which module type main circuit semiconductor switching elements of a power transformer for controlling induction motors are mounted on one surface of a heat receiving panel, and a heat pipe bent in L-shape is embedded at an absorber portion thereof in the other surface of the heat receiving panel and provided with radiation fins at a condenser portion thereof. Further, Japanese Patent Unexamined Publication No. 62-255266 (Document 2) discloses a technology of cooling an inverter which controls an induction motor, in which cooling water for cooling a diesel engine is also circulated through the inverter.

The electric power transforming apparatus for the electric rolling stock, particularly an electric tram, is required to be made smaller in size and lighter in weight because it is installed under the floor of the rolling stock body. It is therefore necessary to increase the mounting density of equipments. As the mounting density is increased, the heating density of the electric devices housed in the casing is increased. In order to efficiently cool the wholeness, there are required a radiator and radiation structure for efficiently cooling the electric devices in the enclosed chamber, as well as a radiation for the exclusive use of the semiconductor switching elements.

Further, the rotating machinery such as fan and pump used for efficiently cooling the electric devices needs a periodical replacement of parts and maintenance because they have wearing parts. Meanwhile, the radiator for the semiconductor switching element needs a periodical cleaning because dust and the like tend to collect inside the radiator. Therefore, in cases where these equipments are installed under the floor of the rolling stock body, considerations on mounting must be given such that the maintenance and inspection could be easily performed.

In the structure disclosed in Document 1, since the module type switching elements can be mounted on only one surface of the heat receiving panel, it is difficult to increase the mounting density. Further, in most cases plural heat pipes must be used for cooling, and therefore in order to expose the fins of all the heat pipes to cooling air, the arrangement of the heat pipes, i.e., the arrangement of equipment as an electric power transforming apparatus are determined by the circumstances of the cooling system, thus giving a problem that the degree of freedom of design of the arrangement of equipment is low.

Meanwhile, in Document 2, a cooling water circuit is disclosed, but no consideration of the mounting is given.

### SUMMARY OF THE INVENTION

An object of the present invention is to provide an electric power transforming apparatus for an electric rolling stock which has a structure capable of increasing the degree of freedom to arrange equipments and efficiently cooling radiators for cooling semiconductor switching elements and other electric device in an enclosed chamber simultaneously, even if the mounting density is increased.

A second object of the present invention is to provide an electric power transforming apparatus for an electric rolling stock which has a cooling structure that facilitates the maintenance of rotating machinery and heat exchangers.

A third object of the present invention is to provide an electric power transforming apparatus for an electric rolling stock which is capable of cooling an enclosed chamber even if the transformer capacity is increased to increase the quantity of heat generated in the enclosed chamber.

The above first object can be achieved by an electric rolling stock having an electric power transforming apparatus, comprising: a power transformer enclosed in a chamber and including a plurality of switching elements for controlling an induction motor for driving the electric rolling stock; cooling means for cooling the power transformer; a heat receiving panel having the switching elements mounted thereon and a cooling liquid passageway formed inside; a heat exchanger for exchanging heat between the cooling liquid from the heat receiving panel and air; a pump for circulating the cooling liquid between the heat receiving panel and the heat exchanger; and blower means for sending cooling air to the heat exchanger, wherein the heat receiving panel, the heat exchanger, the pump and the blower means are installed under the floor of the electric rolling stock, the heat exchanger is disposed adjacent to one side of the electric rolling stock, and the blower means is arranged so that the cooling air is taken in from the other side of the rolling stock where the heat exchanger is not disposed and discharged from the one side where said heat exchanger is disposed.

The second object can be achieved by an electric rolling stock having an electric power transforming apparatus comprising: a power transformer enclosed in a chamber and including a plurality of switching elements for controlling an induction motor for driving the electric rolling stock; cooling means for cooling the power transformer; a heat receiving panel having the switching elements mounted thereon and a cooling liquid passageway formed inside; a heat exchanger for exchanging heat between the cooling liquid from the heat receiving panel and air; a pump for circulating the cooling liquid between the heat receiving panel and the heat exchanger; and means for allowing the heat receiving panel, the heat exchanger and the pump to be taken out as one unit from one side of the electric rolling stock, wherein the heat exchanger is disposed adjacent to one side of the electric rolling stock.

The third object can be achieved by an electric rolling stock having an electric power transforming apparatus, comprising: a power transformer including a plurality of switching elements for controlling an induction motor for driving the electric rolling stock; cooling means for cooling the power transformer; a heat receiving panel having the switching elements mounted thereon and a cooling liquid passageway formed inside; a heat exchanger for exchanging heat between the cooling liquid from the heat receiving panel and air; and blower means for sending cooling air to the heat exchanger, wherein the heat receiving panel is arranged in a chamber provided under the floor of the electric rolling stock and having radiation fins provided on the outside thereof, and the blower means is arranged so that the cooling air is sent toward the side of the rolling stock through the radiation fins.

### BRIEF DESCRIPTION OF THE DRAWINGS

Fig. 1 is a sectional view of an electric rolling stock equipped with a first embodiment of an electric power transforming apparatus according to the present invention, as viewed from a direction in which the rolling stock is running;
Fig. 2 is a cross sectional view of the electric power transforming apparatus taken along line II - II of Fig. 1;
Fig. 3 is a cross sectional view of the electric power transforming apparatus similar to Fig. 2 but taken along line III - III of Fig. 1 and showing the flow of cooling air;
Figs. 4A and 4B are a front view and a side view of a heat receiving panel, respectively;
Fig. 5 is a perspective view showing the inside of a main circuit enclosed chamber;
Fig. 6 is a perspective view of the outside of a main circuit enclosed chamber of a second embodiment of an electric power transforming apparatus according to the present invention showing the flow of cooling air;
Fig. 7 is a view of a third embodiment of an electric power transforming apparatus according to the present invention as viewed from the side of the rolling stock;
Fig. 8 is a view of a fourth embodiment of an electric power transforming apparatus according to the present invention as viewed from the side of the rolling stock; and
Fig. 9 is a main circuit diagram of the electric power transforming apparatus.

### DETAILED DESCRIPTION OF THE PREFERRED EMBODIMENTS

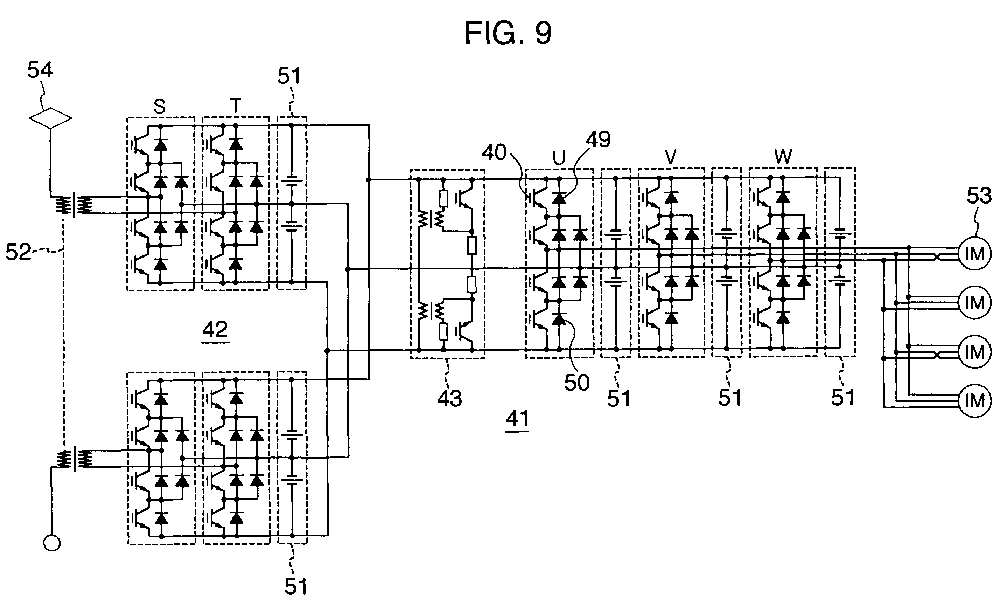

Now, description will be given of an electric power transforming apparatus equipped with both converter and inverter and installed under the floor of an electric rolling stock with reference to Fig. 9. Fig. 9 shows an electric power transforming apparatus for an electric rolling stock running through an AC feeder section. An alternating current picked up through a pantograph 54 is reduced in voltage and distributed by a plurality of transformers 52 and then inputted to AC input terminals of single-phase three-level converters 42. Each converter 42 outputs three levels of direct currents including positive, negative and neutral levels of direct currents which are connected to filter capacitors 51 in parallel relation to each other and inputted to the direct current terminals of a three-phase three-level inverter 41. The direct current terminals of U-, V- and W-phases of the inverter 41 are connected with respective filter capacitors 51. The inverter 41 transforms the inputted direct currents into pulses each having three levels, i.e., positive, negative and neutral levels, and outputs three-phase alternating currents which are PWM modulated and have variable voltage and variable frequency. Induction motors 53 have their rotation controlled by the variable voltage and variable frequency alternating currents, which causes power running of the electric rolling stock. At the time of regeneration when the induction motors 53 work as generators, energy flows back to the pantograph 54 in reverse manner to the case of the power running.

An overvoltage control circuit 43 connected in parallel between the converters 42 and the inverter 41 reduces the voltage by short-circuiting through resistors when the DC voltage is increased in excess due to some reason and works when the potential of the neutral point becomes unbalanced between positive and negative levels (this work never exists in the case of a two-level inverter).

By the way, switching elements 40 constituting the inverter 41 and the converter 42 are module type self-arc-extinguish type switching elements such as IGBT (Insulated Gate Bipolar Transistor), GTO (Gate Turn Off Thyrister) and the like, for example. Each of IGBTs used in this embodiment is integrated with a fly wheel diode 50 connected in parallel therewith to form a module. The diodes connected in parallel with two of the four switching elements 40 connected in series are clamp diodes 49 and are peculiar to the three-level power transformer which generate neutral potential. Further, although not shown in Fig. 9, each switching element is provided with a snubber circuit for absorbing an overvoltage caused upon self arc extinguishing, the snubber circuit comprising snubber diode, snubber resistor and snubber capacitor.

All of the above-described elements constituting the electric power transforming apparatus are heat generating members for the cooling system, and therefore if these elements are densely mounted, the cooling system becomes serious from the thermal point of view. Meanwhile, considering the maintenance, layout of the elements is also important but it is not always the convenient one for the cooling system. A cooling system structure of the invention which is to be described below can meet such requirement.

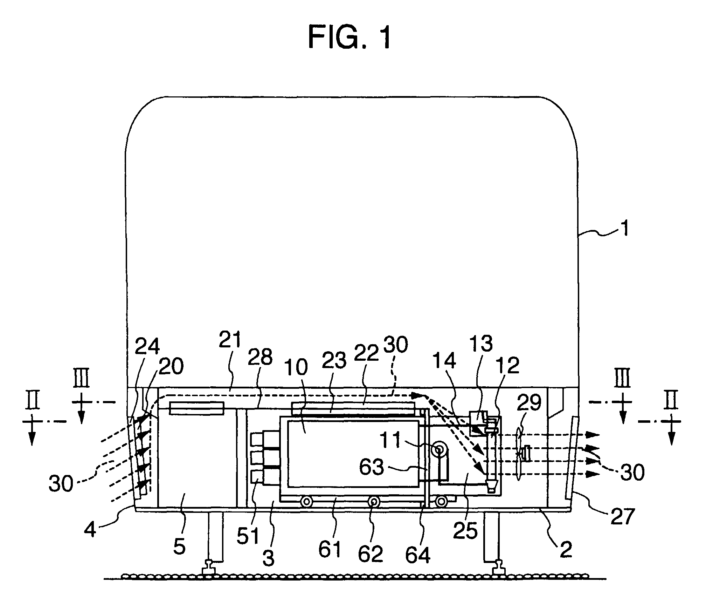

Now, description will be given of a first embodiment of the present invention with reference to Figs. 1 to 5. In this embodiment, a circulating liquid cooling system is adopted in which a cooling liquid is passed through a heat receiving panel mounted with module type semiconductor switching elements 40 which constitute the power transformer, and circulated through an air-liquid heat exchanger to cool the heat receiving panel. In this case, a refrigerant to be used is water or water solution containing the component of ethylene glycol which suppresses freezing under low temperature conditions, for example.

In Fig. 1 (in which the electric wiring is omitted), a casing 2 housing a power transformer is suspended under the floor of a rolling stock body 1 by means of hanging members (not shown) leaving a space for an air duct 21. In the casing 2, an electric device enclosed chamber 5, a main circuit enclosed chamber 3 containing the main circuit of the power transformer and a cooling unit are arranged widthwise of a track in this order from the left of the drawing sheet. The filter capacitors 51 are disposed in the main circuit enclosed chamber 3. In the main circuit enclosed chamber 3 containing the power transformer main circuit are provided a heat receiving panel 10 and other main circuit components which will be described below in detail. Above the main circuit enclosed chamber 3 is formed the air duct 21 by making use of the surface of a top plate 28 of the main circuit enclosed chamber 3 adjacent to the rolling stock body, and external radiation fins 22 are so provided on the outside of the main circuit enclosed chamber 3 as to be located in the air duct 21. Internal radiation fins 33 are provided inside the main circuit enclosed chamber 3 so as to be opposite to the external radiation fins 22 across the top plate 28.

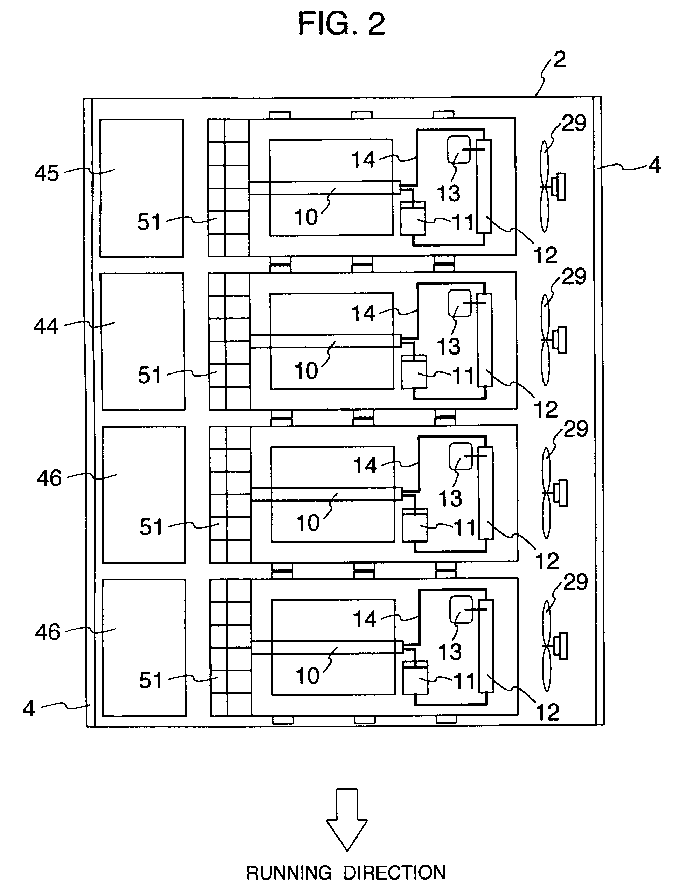

Meanwhile, as shown in Fig. 2, on the right side of the casing 2 with respect to the running direction of the rolling stock (on the left side in the drawing), there are provided electric devices such as a gate control device 44 which generates PWM gate signals for the switching elements 40 constituting the converter 42 and inverter 41, an AC contactor 45 for electrically cutting off the AC electric traction from such control device, and control power supplies 46 for supplying electric power to the various control devices, which devices are divided into groups and housed in the separate electric device enclosed chambers 5, and arranged along the side of the casing 2 over the whole length thereof.

A liquid circulating pump 11, an air blower 29, an air-liquid heat exchanger (radiator) 12 and a reserve tank 13, which are the constituents of a cooling system, are disposed on the right side of the main circuit enclosed chamber 3 (on the right side in the drawing). These equipments and the heat receiving panel 10 contained in the main circuit enclosed chamber 3 are connected with each other through a piping 14.

Cooling water pressurized by the liquid circulating pump 11 is supplied to the heat receiving panel 10 contained in the main circuit enclosed chamber 3. The heat receiving panel 10 has the elements to be cooled of one phase (S-phase, T-phase, U-phase, V-phase or W-phase) of the converter 42 and inverter 41 or the elements to be cooled of the overvoltage control circuit 43 mounted on one or both of the surfaces thereof. Inside the heat receiving panel 10 is formed a passageway through which the cooling water flows. When the cooling water from the liquid circulating pump 11 flows through the water passage, it absorbs heat generated from the elements to be raised in temperature, and the cooling water is then sent to the radiator 12 through the piping 14. Referring to Fig. 1, cooling air is taken in from the outside of the rolling stock so as to flow through the radiator 12, in which case a heat exchange is effected between the cooling water and the air to lower the temperature of the cooling water. Further, the radiator 12 is equipped with the reserve tank 13 for the purpose of suppressing the pressure increase even if the pressure becomes excessive and supplementing the cooling water. The cooling water having left the radiator 12 returns again to the circulating pump 11 and circulates in the described manner to cool the heat generating elements. Incidentally, the quantity of cooling water to be circulated is 40 to 50 liters per minute.

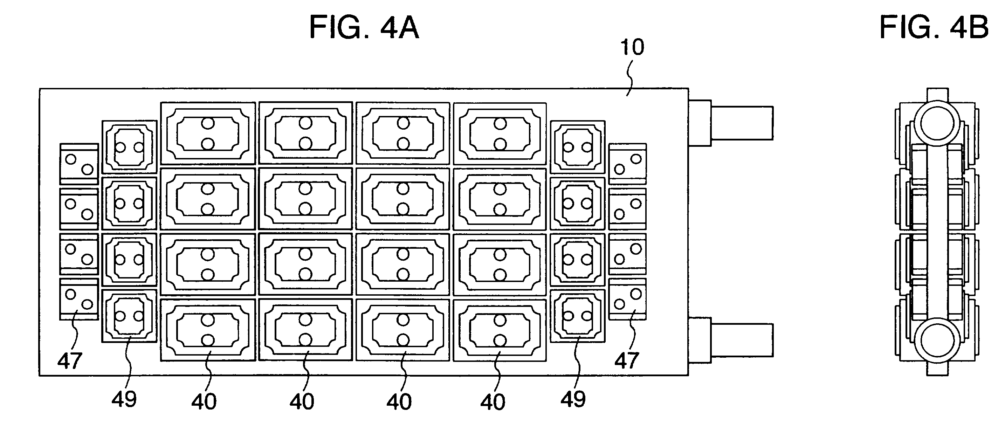

Now, description will be given of the layout of the electric power transforming apparatus of this embodiment with reference to Fig. 2. The casing 2 is arranged inside skirts 4 forming both sides of the rolling stock body 1. In the casing 2 are arranged four heat receiving panels 10, four cooling equipments (each comprising the liquid circulating pump 11, radiator 12, reserve tank 13 and piping 14), the gate control device 44, the AC contactor 45 and two power supplies 46 for control as shown in the drawing. As shown in Fig. 4, since the elements to be cooled can be mounted on the both surfaces of the heat receiving panel 10, the mounting density is made higher as compared with the case of Document 1 in which the elements to be cooled are described as being mounted on one surface. For instance, in the main circuit diagram shown in Fig. 9, it is required to cool the elements of eight phases in all, that is, the elements of the converter 42 of four phases consisting of two sets of S- and T-phases, the elements of the inverter 41 of three phases consisting of U-, V- and W-phases, and the elements of the overvoltage control circuit 43 considered as being of one phase. The number of the heat receiving panels 10 shown in Fig. 2 is four and the elements of one phase can be mounted on one surface, and therefore it becomes possible to cool the elements of eight phases in all. The elements of one phase are mounted on one surface because of large capacity, and however this is not limitative in the case of a two-level inverter or a small capacity type. Further, the heat receiving panel 10 is disposed upright with respect to the bottom surface of the casing 2 so that the surface on which the elements to be cooled are are mounted is arranged to be perpendicular to the running direction of the rolling stock. In the arrangement disclosed in Document 1, it is necessary to arrange the heat receiving panel so that the surface thereof to which the heat pipe is attached forms the side of the rolling stock body 1. The panel of this embodiment can be made short in lengthwise direction of the rolling stock body 1. In order to obtain this effect, it will do if the surface of the heat receiving panel 10 on which the elements are mounted faces in the running direction of the rolling stock, and the heat receiving panel 10 may be disposed upright in diagonal manner.

Now, description will be given of the cooling air intake and exhaust structure. Referring to Fig. 1, air is taken in a draft chamber 25 via an intake port 24 formed in the skirt 4 located in the side of the rolling stock, an air filter 20 and the air duct 21 defined by a space between the rolling stock body 1 and the casing 2. This cooling air 30 is passed through the air-liquid heat exchanger 12 and the air blower 29 to be discharged out of an exhaust port 27 located in the side of the rolling stock. Namely, a side-intake side-exhaust structure is adopted. In this way, since the cooling air 30 is taken in from the side and discharged sideways, the flowing direction of the cooling air inside the casing 2 is not remarkably changed, resulting in a small pressure loss. It is therefore possible to ensure a larger quantity of air with the blower means of the same power. In consequence, it is possible to improve the overall cooling efficiency of the electric power transforming apparatus.

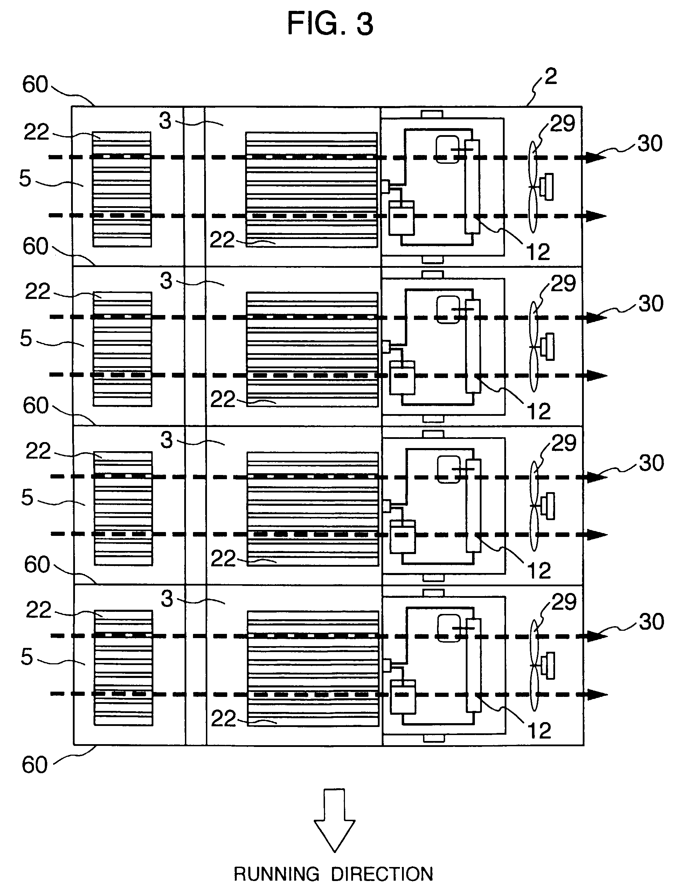

Referring to Fig. 3, the external radiation fins 22 are provided on the top plate 28 forming the air duct 21 in those portions corresponding to the enclosed chamber 3, 5, while the radiator 12 and the like are disposed in the vicinity of the side of the rolling stock body, and a passageway is formed in such a manner that the cooling air 30 is caused to flow toward the radiator 12. The cooling air 30 coming through the air filter 20 attached to the side skirt 4 of the rolling stock body 1 flows into the air duct 21 divided by partition plates 60 and, after passing through the external radiation fins 22, it is taken in the radiator 12. With such construction, if the air is discharged from the bottom, the passageway must have such structure that the flowing direction of the cooling air taken in the casing 2 is changed at right angles (from lateral to downward), which causes the pressure loss in this portion to increase and the quantity of cooling air to decrease, resulting in the deterioration of the cooling efficiency.

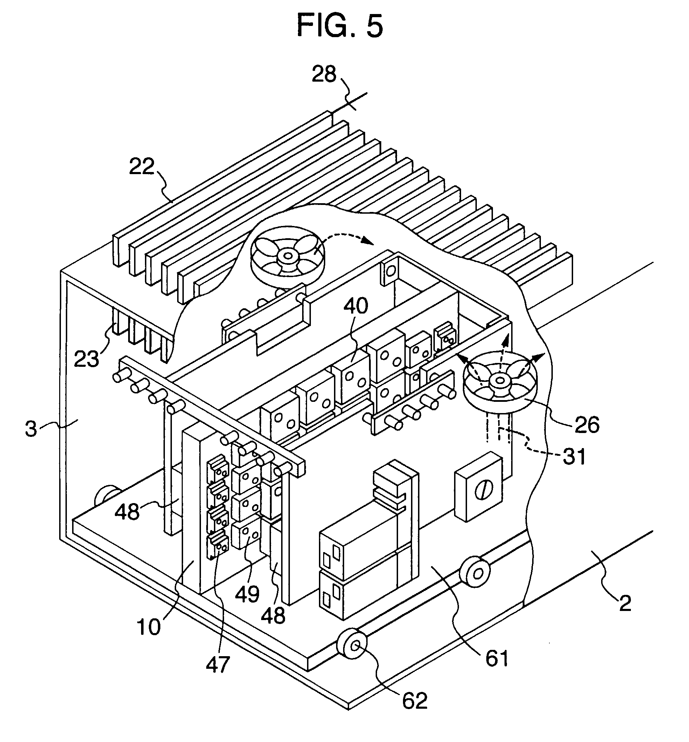

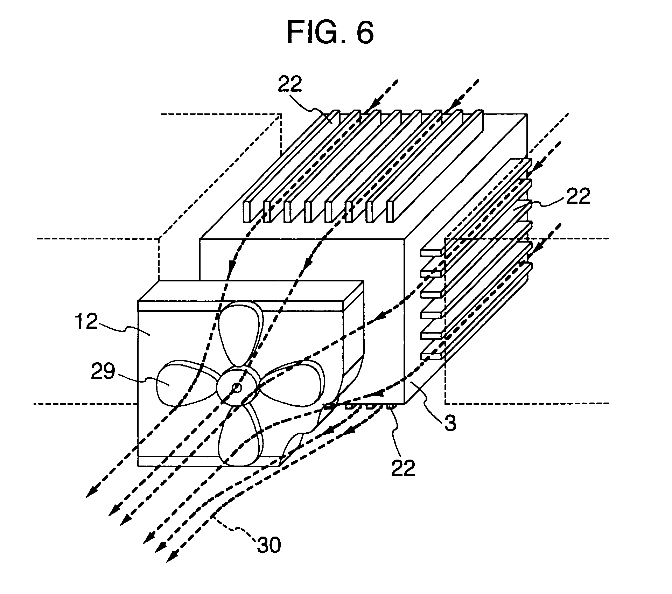

Now, description will be given of how to cool the main circuit enclosed chamber 3 and the electric device enclosed chamber 5 which prevent the open air from entering with reference to Figs. 5 and 6. The elements mounted on the heat receiving panel 10 are cooled in the manner described above. As shown in Fig. 5, a snubber capacitor 48 which is one of the electric devices constituting the snubber circuit contained in the main circuit enclosed chamber 3, filter capacitors 51 (not shown), gate amplifier (not shown) which receives a signal from the gate control circuit 44 and amplifies the same to supply a switching signal to the switching element constituting the power transformer and other related parts are also contained in the main circuit enclosed chamber 3. The quantity of heat generated from the switching elements mounted on the heat receiving panel 10 is large so that the temperature of the heat receiving panel 10 becomes 75°C to 80°C even if water is passed through the inside thereof during the operation of the power transformer. On the other hand, the allowable temperature of the snubber capacitor 48 and gate amplifier is in the range from 40 to 50°C. For this reason, the temperature in the main circuit enclosed chamber 3 will exceed the allowable temperature of these related parts attributed to the heat generated from the heat receiving panel 10 if no measures are taken. In the present embodiment, the heat receiving panel 10 is disposed upright so that the heat generated is transferred to the ambient air in the main circuit enclosed chamber 3. At this time, the air in the main circuit enclosed chamber 3 forms the ascending current to transport the heat mainly to the internal radiation fins 23 provided in the upper part. Meanwhile, the external radiation fins 22 are also provided on the upper face of the main circuit enclosed chamber 3 within the air duct 21 (see Fig. 1). The cooling air 30 produced by the air blower 29 and taken in through the air filter 20 is passed through the external radiation fins 22 without substantially raising the temperature (the temperature rise of the cooling air owing to the radiation of heat from the electric device enclosed chamber 5 is about 1°C at the most), and therefore the heat transfer from the upper face of the main circuit enclosed chamber is promoted. This makes it possible to efficiently cool the main circuit enclosed chamber 3. In this case, a fan 26 may be provided in the enclosed chamber for stirring the air within the enclosed chamber and guiding a wind toward the radiation fins for the purpose of promoting the radiation. Further, it is more effective to make a difference in shape between the radiation fins 22 and 23 in accordance with respective speeds of the air flow because the air flows through the radiation fins 22, 23 at different speeds. Moreover, the electric device enclosed chamber 5 is constructed in the same manner as well.

Now, description will be given of the maintenance with reference to Fig. 1 or Fig. 5. It is advisable to perform the maintenance and inspection from the side of the rolling stock. In this embodiment, the draft chamber 25 housing the rotating machinery which must undergo a periodical maintenance and inspection is arranged to be located adjacent to the side of the rolling stock body 1. The reason for this layout which facilitates the maintenance and inspection is that adoption of the water cooling system caused the air-cooled parts to be concentrated to the radiator 12.

Meanwhile, on the side of the main circuit enclosed chamber 3, the heat receiving panel 10, the liquid circulating pump 11, the radiator 12, the reserve tank 13 and the piping 14 are placed on a truck 61 with wheels 62 together with the other main circuit component parts including the filter capacitors 51, so that they can be moved as one unit widthwise of the rolling stock body 1 by releasing wheel stoppers (not shown). In this case, the air blower 29 may be placed on the truck so as to be movable simultaneously with the heat receiving panel 10 and other parts, or may be placed in such a manner that only the air blower 29 can be moved (removed) independently, in which case the maintenance of the air blower 29 comprising the rotating parts can be facilitated.

The truck 61 having undergone the maintenance and inspection is put back to the position shown in the drawing where a partition plate 63 attached to the truck 61 adjacent to the radiator 12 is brought into contact with a stopper 64 hollowed out like a picture frame and covered with rubber packing and fixed to the casing 2 to form the main circuit enclosed chamber. At the same time, by abutting the partition plate 63 on the stopper 64, the draft chamber 25 is formed.

As described above, according to this embodiment, since it becomes possible to mount more than one element on either surface of the water-cooled heat receiving panel, the mounting density can be improved while maintaining a predetermined cooling efficiency. Further, the draft chamber 25 is formed under the floor of the rolling stock body 1 adjacent to the side of the rolling stock and the radiator 12 is disposed in the draft chamber 25, and therefore the working performance at the time of maintenance and inspection can advantageously be enhanced as described above.

In the above embodiment, the radiation fins are provided only in the upper part of the enclosed chamber. However, as shown in a second embodiment of Fig. 6, the radiation fins may be provided on the side and lower faces of the enclosed chamber in addition to the upper face, in which case the air duct may be so formed as to cause the cooling air to pass through these faces. In this case, since the radiation area of the main circuit enclosed chamber 3 is increased, the cooling efficiency of the enclosed chamber is enhanced. Further, the flowing direction of the cooling air is not remarkably changed and the sectional area available for intake of the cooling air is increased, and therefore the pressure loss is reduced to make it possible to ensure a large quantity of air. In consequence, the cooling efficiencies of the enclosed chamber and the radiator are improved. For the above reasons, the cooling efficiency can be improved as a whole.

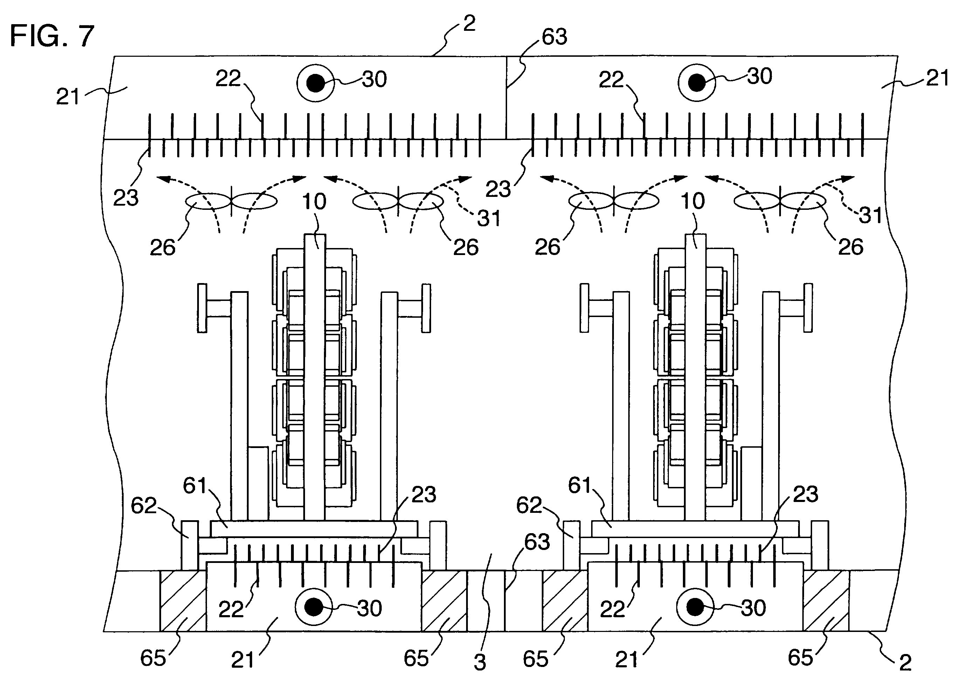

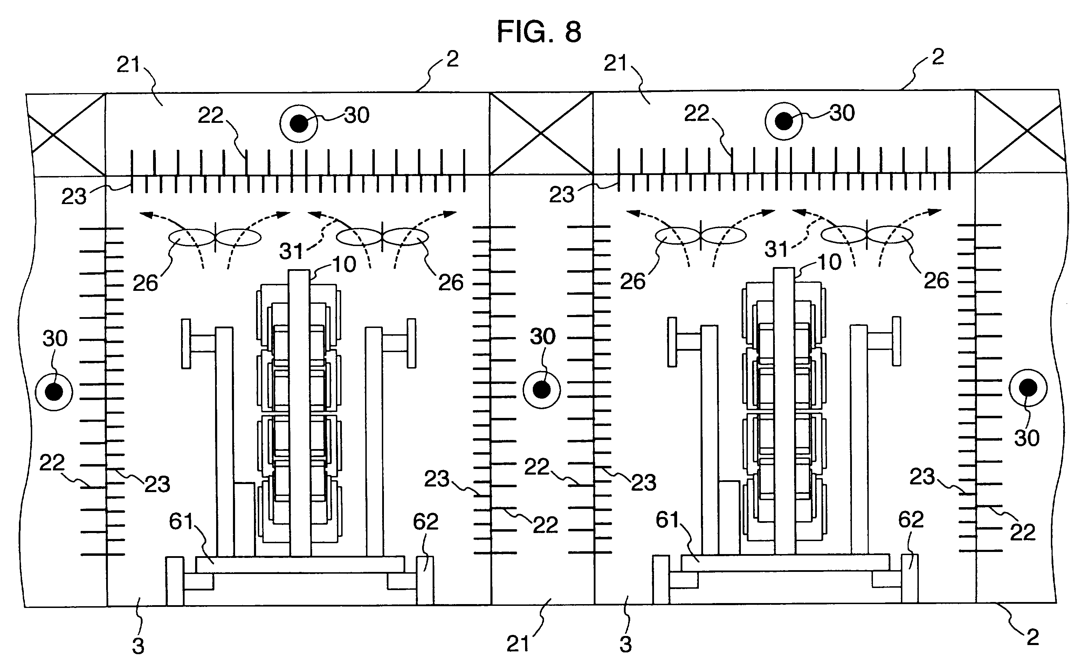

Third and fourth embodiments will be described with reference to Figs. 7 and 8. Fig. 7 is a drawing as viewed from the side of the rolling stock, which shows a case where the radiation fins are provided on the upper and lower faces of the enclosed chamber. The structure of the upper face is the same as that of the first embodiment. A partition plate is provided between the lower surface of the casing 2 and the truck 61 so as to form an air duct 21 for cooling from the lower face of the enclosed chamber in cooperation with supporting beds 65 for supporting the wheels 62, and the radiation fins 22, 23 are provided on this partition plate. Cooling air 30 is made to pass through the duct 21 perpendicularly to the drawing sheet. Fig. 8 is a drawing as viewed from the side of the rolling stock, which shows a case where the radiation fins are provided on the upper and side faces of the enclosed chamber. The structure of the upper face is the same as that of the first embodiment. Two partition plates are provided between the heat receiving panels 10 to form an air duct 21 for cooling from the side of the enclosed chamber, and the radiation fins 22, 23 are provided on the partition plates. Cooling air 30 is made to pass through the air duct 21 perpendicularly to the drawing sheet.

The above embodiments have been described as to the electric power transforming apparatus in the converter-inverter system in which alternating currents are fed to drive the induction motors which are alternating-current motors. However, the present invention is not limited to this system but is also applicable in the inverter system in which direct currents are fed to drive the induction motors. Moreover, the inverter or converter has been described above as being a three-level power transformer but it doesn't matter if it is a two-level power transformer. Further, description has been made about the construction that the elements are arranged on both surfaces of the heat receiving panel 10, and however this invention is also applicable to the construction that the elements are arranged only one surface, in which case it is possible to freely design the apparatus according to other design requirements regardless of the cooling system. In addition, the radiation fins can selectively be formed on the enclosed chamber in dependent on the quantity of heat generated in the enclosed chamber. For instance, it is possible to provide no radiation fin on the side face but form only an air duct through which cooling air is passed. Furthermore, an axial fan is shown as the air blower for taking cooling air in the casing, but the present invention is not limited to this and is applicable with the use of a centrifugal fan, for example. Besides, description has been made about the case where the truck 61 and the wheels 62 are used for the means by which the heat receiving panel 10, the liquid circulating pump 11 and the radiator 12 can be integrally taken out from the side of the electric rolling stock, but the present invention is not limited to this and is applicable by providing a sliding portion and a suspending portion, for example.

According to the present invention described above, it becomes possible to increase the degree of freedom of electric device arrangement and to efficiently cool the radiator and the enclosed chamber for the semiconductor switching elements simultaneously, and furthermore the working performance of maintenance and inspection of the rotating machinery and heat exchanger is enhanced, and therefore even if the transformer capacity is further increased to increase the quantity of heat generated in the enclosed chamber, the enclosed chamber can be cooled sufficiently.

## Claims

1. An electric rolling stock having an electric power transforming apparatus, comprising
a power transformer (41, 42) enclosed in a chamber (3) and including a plurality of switching elements (40) for controlling an induction motor (53) for driving the electric rolling stock,
cooling means for cooling said power transformer (41, 42),
a heat receiving panel (10) having said switching elements (40) mounted thereon and a cooling liquid passageway formed inside,
a heat exchanger (12) for exchanging heat between the cooling liquid from said heat receiving panel (10) and air, and
blower means (29) for sending cooling air to said heat exchanger (12),
wherein said heat receiving panel (10), said heat exchanger (12), and said blower means (29) are installed under the floor of the electric rolling stock,
**characterised** in
that a pump (11) for circulating said cooling liquid between said heat receiving panel (10) and said heat exchanger (12) is installed under the floor of the electric rolling stock,
that said heat exchanger (12) is disposed adjacent to one side of said electric rolling stock, and
that said blower means (29) is arranged so that the cooling air is taken in from the other side of said rolling stock where said heat exchanger (12) is not disposed and discharged from said one side where said heat exchanger (12) is disposed.

2. The apparatus of claim 1, wherein said heat receiving panel (10) is disposed upright so that a surface of said heat receiving panel (10) on which the elements are mounted faces in the running direction of the electric rolling stock.

3. An electric rolling stock having an electric power transforming apparatus, comprising
a power transformer (41, 42) enclosed in a chamber (3) and including a plurality of switching elements (40) for controlling an induction motor (53) for driving the electric rolling stock,
cooling means for cooling said power transformer (41, 42),
a heat receiving panel (10) having said switching elements (40) mounted thereon and a cooling liquid passageway formed inside, and
a heat exchanger (12) for exchanging heat between the cooling liquid from said heat receiving panel (10) and air,
**characterised** in
that a pump (11) is provided for circulating said cooling liquid between said heat receiving panel (10) and said heat exchanger (12),
that means is provided for allowing said heat receiving panel (10), said heat exchanger (12) and said pump (11) to be taken out as one unit from one side of the electric rolling stock, and
that said heat exchanger (12) is disposed adjacent to said side of the electric rolling stock.

4. The apparatus of claim 3, further comprising blower means (29) for sending cooling air to said heat exchanger (12), wherein said blower means (29) can be taken out from the side of the electric rolling stock independently of said heat receiving panel (10), said heat exchanger (12) and said pump (11).

5. The apparatus of claim 3, further comprising blower means (29) for sending cooling air to said heat exchanger (12), wherein said blower means (29), said heat receiving panel (10), said heat exchanger (12) and said pump (11) can be taken out as one unit from the side of the electric rolling stock.

6. The apparatus of claim 3, wherein said heat receiving panel (10) is disposed upright so that a surface of said heat receiving panel (10) on which the elements are mounted faces in the running direction of the electric rolling stock.

7. An electric rolling stock having an electric power transforming apparatus, comprising
a power transformer (41, 42) including a plurality of switching elements (40) for controlling an induction motor (53) for driving the electric rolling stock,
cooling means for cooling said power transformer (41, 42),
a heat receiving panel (10) having said switching elements (40) mounted thereon and a cooling liquid passageway formed inside,
a heat exchanger (12) for exchanging heat between the cooling liquid from said heat receiving panel (10) and air, and
blower means (29) for sending cooling air to said heat exchanger (12),
wherein said heat receiving panel (10) is arranged in a chamber provided under the floor of the electric rolling stock
**characterised in**
that the heat receiving panel (10) has radiation fins (22) provided on the outside thereof, and said blower means (29) is arranged so that the cooling air is sent toward the side of the rolling stock through said radiation fins (22).

8. The apparatus of claim 7, wherein said blower means (29) is arranged so that the cooling air is sent through said radiation fins (22) and said heat exchanger (12) in this order.

9. The apparatus of claim 7, wherein said blower means (29) is arranged so that the cooling air flows through said heat exchanger (12) and said blower means (29) in this order.

10. The apparatus of claim 7, wherein the radiation fins (22) are provided on upper and lower faces or on upper and side faces of said chamber.

## Patentansprüche

1. Elektrisches Schienenfahrzeug mit einer elektrischen Leistungstransformationsvorrichtung, umfassend
einen Leistungstransformator (41, 42), der sich innerhalb einer Kammer (3) befindet und der mehrere Schaltelemente (40) zum Steuern eines Induktionsmotors (53) zum Antreiben des elektrischen Schienenfahrzeugs einschließt,
eine Kühleinrichtung zum Kühlen des Leistungstransformators (41, 42),
eine Wärmeaufnahmeplatte (10), an der die Schaltelemente (40) befestigt sind und in deren Innern ein Kanal für Kühlflüssigkeit ausgebildet ist,
einen Wärmetauscher (12) zum Wärmeaustausch zwischen der Kühlflüssigkeit aus der Wärmeaufnahmeplatte (10) und Luft, und
ein Gebläse (29) zum Schicken von Kühlluft zum Wärmetauscher (12),
wobei die Wärmeaufnahmeplatte (10), der Wärmetauscher (12) und das Gebläse (29) unter dem Boden des Schienenfahrzeugs angebracht sind,
dadurch **gekennzeichnet**, daß eine Pumpe (11) zum Umwälzen der Kühlflüssigkeit zwischen der Wärmeaufnahmeplatte (10) und dem Wärmetauscher (12) unter dem Boden des elektrischen Schienenfahrzeugs angebracht ist,
daß der Wärmetauscher (12) an eine Seite des elektrischen Schienenfahrzeugs angrenzend angeordnet ist, und
daß das Gebläse (29) so angeordnet ist, daß die Kühlluft von der anderen Seite des Schienenfahrzeugs, auf der der Wärmetauscher (12) nicht angeordnet ist, aufgenommen wird und auf der Seite, auf der der Wärmetauscher angeordnet ist, abgegeben wird.

2. Vorrichtung nach Anspruch 1, bei der die Wärmeaufnahmeplatte (10) aufrecht angeordnet ist, so daß die Fläche der Wärmeaufnahmeplatte (10), auf der die Elemente befestigt sind, in Fahrtrichtung des elektrischen Schienenfahrzeugs zeigt.

3. Elektrisches Schienenfahrzeug mit einer elektrischen Leistungstransformationsvorrichtung, umfassend:
einen Leistungstransformator (41, 42), der sich innerhalb einer Kammer (3) befindet und der mehrere Schaltelemente (40) zum Steuern eines Induktionsmotors (53) zum Antreiben des elektrischen Schienenfahrzeugs einschließt,
eine Kühleinrichtung zum Kühlen des Leistungstransformators (41, 42),
eine Wärmeaufnahmeplatte (10), an der die Schaltelemente (40) befestigt sind und in deren Innern ein Kanal für Kühlflüssigkeit ausgebildet ist,
einen Wärmetauscher (12) zum Wärmeaustausch zwischen der Kühlflüssigkeit aus der Wärmeaufnahmeplatte (10) und Luft,
dadurch **gekennzeichnet,** daß eine Pumpe (11) zum Umwälzen der Kühlflüssigkeit zwischen der Wärmeaufnahmeplatte (10) und dem Wärmetauscher (12) vorgesehen ist,
daß eine Einrichtung vorgesehen ist, die es erlaubt, daß die Wärmeaufnahmeplatte (10), der Wärmetauscher (12) und die Pumpe (11) an einer Seite des elektrischen Schienenfahrzeugs als eine Einheit zu entnehmen sind, und
daß der Wärmetauscher (12) an dieser Seite des elektrischen Schienenfahrzeugs angeordnet ist.

4. Vorrichtung nach Anspruch 3, die zusätzlich ein Gebläse (29) zum Schicken von Kühlluft zum Wärmetauscher (12) umfaßt, wobei das Gebläse (29) unabhängig von der Wärmeaufnahmeplatte (10), dem Wärmetauscher (12) und der Pumpe (11) an der Seite des elektrischen Schienenfahrzeuges herausgenommen werden kann.

5. Vorrichtung nach Anspruch 3, die weiterhin ein Gebläse (29) zum Schicken von Kühlluft zum Wärmetauscher (12) umfaßt, wobei das Gebläse (29), die Wärmeaufnahmeplatte (10), der Wärmetauscher (12) und die Pumpe (11) als eine Einheit an der Seite des elektrischen Schienenfahrzeugs herausgenommen werden können.

6. Vorrichtung nach Anspruch 3, bei der die Wärmeaufnahmeplatte (10) aufrecht angeordnet ist, so daß eine Fläche der Wärmeaufnahmeplatte (10), auf der die Elemente befestigt sind, in Fahrtrichtung des elektrischen Schienenfahrzeugs zeigt.

7. Elektrisches Schienenfahrzeug mit einer elektrischen Leistungstransformationsvorrichtung, umfassend
einen Leistungstransformator (41, 42), der mehrere Schaltelemente (40) zum Steuern eines Induktionsmotors (53) zum Antreiben des elektrischen Schienenfahrzeugs einschließt,
eine Kühleinrichtung zum Kühlen des Leistungstransformators (41, 42),
eine Wärmeaufnahmeplatte (10), an der die Schaltelemente (40) befestigt sind und in deren Innern ein Kanal für Kühlflüssigkeit ausgebildet ist,
einen Wärmetauscher (12) zum Wärmeaustausch zwischen der Kühlflüssigkeit aus der Wärmeaufnahmeplatte 10 und Luft, und
ein Gebläse (29) zum Schicken von Kühlluft zum Wärmetauscher (12),
wobei die Wärmeaufnahmeplatte (10) in einer Kammer angeordnet ist, die unter dem Boden des elektrischen Schienenfahrzeugs vorgesehen ist,
dadurch **gekennzeichnet,** daß die Wärmeaufnahmeplatte (10) an ihrer Außenseite mit Kühlrippen (22) versehen ist und das Gebläse (29) so angeordnet ist, daß die Kühlluft durch die Kühlrippen (22) zur Seite des Schienenfahrzeugs geschickt wird.

8. Vorrichtung nach Anspruch 7, wobei das Gebläse (29) so angeordnet ist, daß die Kühlluft zuerst durch die Kühlrippen (22) und dann durch den Wärmetauscher (12) hindurchgeschickt wird.

9. Vorrichtung nach Anspruch 7, wobei das Gebläse (29) so angeordnet ist, daß die Luft zuerst durch den Wärmetauscher (12) und dann durch das Gebläse (29) hindurchfließt.

10. Vorrichtung nach Anspruch 7, wobei die Kühlrippen (22) an den oberen und unteren Flächen oder an den oberen und seitlichen Flächen der Kammer vorgesehen sind.

## Revendications

1. Véhicule ferroviaire électrique ayant un dispositif de transformation d'énergie électrique, comprenant
un transformateur (41, 42) de courant logé dans une enceinte (3) et comportant une pluralité d'éléments de commutation (40) pour commander un moteur asynchrone (53) servant à entraîner le véhicule ferroviaire électrique,
un moyen de refroidissement pour refroidir ledit transformateur (41, 42) de courant,
un panneau (10) de réception de chaleur sur lequel sont montés lesdits éléments de commutation (40) et à l'intérieur duquel est formé un passage de liquide de refroidissement,
un échangeur (12) de chaleur pour échanger de la chaleur entre le liquide de refroidissement provenant dudit panneau (10) de réception de chaleur et l'air, et
un moyen formant soufflante (29) pour envoyer de l'air de refroidissement audit échangeur (12) de chaleur,
ledit panneau (10) de réception de chaleur, ledit échangeur (12) de chaleur et ledit moyen formant soufflante (29) étant installés sous le plancher du véhicule ferroviaire électrique,
**caractérisé** en
ce qu'une pompe (11) pour faire circuler ledit liquide de refroidissement entre ledit panneau (10) de réception de chaleur et ledit échangeur (12) de chaleur est installée sous le plancher du véhicule ferroviaire électrique,
ce que ledit échangeur (12) de chaleur est disposé au voisinage immédiat d'un premier côté dudit véhicule ferroviaire électrique, et
ce que ledit moyen formant soufflante (29) est agencé de façon que l'air de refroidissement soit introduit de l'autre côté dudit véhicule ferroviaire, où ledit échangeur (12) de chaleur n'est pas disposé, et soit refoulé depuis ledit premier côté, où est disposé ledit échangeur (12) de chaleur.

2. Dispositif selon la revendication 1, dans lequel ledit panneau (10) de réception de chaleur est disposé verticalement de façon qu'une surface dudit panneau (10) de réception de chaleur sur lequel sont montés les éléments soit orientée dans la direction de circulation du véhicule ferroviaire électrique

3. Véhicule ferroviaire électrique ayant un dispositif de transformation d'énergie électrique, comprenant
un transformateur (41, 42) de courant logé dans une enceinte (3) et comportant une pluralité d'éléments de commutation (40) pour commander un moteur asynchrone (53) servant à entraîner le véhicule ferroviaire électrique,
un moyen de refroidissement pour refroidir ledit transformateur (41, 42) de courant,
un panneau (10) de réception de chaleur sur lequel sont montés lesdits éléments de commutation (40) et à l'intérieur duquel est formé un passage de liquide de refroidissement, et
un échangeur (12) de chaleur pour échanger de la chaleur entre le liquide de refroidissement provenant dudit panneau (10) de réception de chaleur et l'air,
**caractérisé** en
ce qu'une pompe (11) est prévue pour faire circuler ledit liquide de refroidissement entre ledit panneau (10) de réception de chaleur et ledit échangeur (12) de chaleur,
ce qu'un moyen est prévu pour permettre audit panneau (10) de réception de chaleur, audit échangeur (12) de chaleur et ladite pompe (11) d'être retirés d'un seul bloc depuis un côté du véhicule ferroviaire électrique, et
ce que ledit échangeur (12) de chaleur est disposé au voisinage immédiat dudit côté du véhicule ferroviaire électrique.

4. Dispositif selon la revendication 3, comprenant en outre un moyen formant soufflante (29) pour envoyer de l'air de refroidissement audit échangeur (12) de chaleur, ledit moyen formant soufflante (29) pouvant être retiré depuis le côté du véhicule ferroviaire électrique indépendamment dudit panneau (10) de réception de chaleur, dudit échangeur (12) de chaleur et de ladite pompe (11).

5. Dispositif selon la revendication 3, comprenant en outre un moyen formant soufflante (29) pour envoyer de l'air de refroidissement audit échangeur (12) de chaleur, ledit moyen formant soufflante (29), ledit panneau (10) de réception de chaleur, ledit échangeur (12) de chaleur et ladite pompe (11) pouvant être retirés d'un seul bloc depuis le côté du véhicule ferroviaire électrique.

6. Dispositif selon la revendication 3, dans lequel ledit panneau (10) de réception de chaleur est disposé verticalement de façon qu'une surface dudit panneau (10) de réception de chaleur sur lequel sont montés les éléments soit orientée dans la direction de circulation du véhicule ferroviaire électrique.

7. Véhicule ferroviaire électrique ayant un dispositif de transformation d'énergie électrique, comprenant
un transformateur (41, 42) de courant comportant une pluralité d'éléments de commutation (40) pour commander un moteur asynchrone (53) servant à entraîner le véhicule ferroviaire électrique,
un moyen de refroidissement pour refroidir ledit transformateur (41, 42) de courant,
un panneau (10) de réception de chaleur sur lequel sont montés lesdits éléments de commutation (40) et à l'intérieur duquel est formé un passage de liquide de refroidissement,
un échangeur (12) de chaleur pour échanger de la chaleur entre le liquide de refroidissement provenant dudit panneau (10) de réception de chaleur et l'air, et
un moyen formant soufflante (29) pour envoyer de l'air de refroidissement audit échangeur (12) de chaleur,
ledit panneau (10) de réception de chaleur étant installé dans une enceinte disposée sous le plancher du véhicule ferroviaire électrique,
**caractérisé** en
ce que le panneau (10) de réception de chaleur comporte extérieurement des ailettes de rayonnement (22), et ledit moyen formant soufflante (29) est agencé de façon que l'air de refroidissement soit envoyé vers le côté du véhicule ferroviaire à travers lesdites ailettes de rayonnement (22).

8. Dispositif selon la revendication 7, dans lequel ledit moyen formant soufflante (29) est agencé de façon que l'air de refroidissement soit envoyé, dans cet ordre, à travers lesdites ailettes de rayonnement (22) et ledit échangeur (12) de chaleur.

9. Dispositif selon la revendication 7, dans lequel ledit moyen formant soufflante (29) est agencé de façon que l'air de refroidissement passe, dans cet ordre, à travers ledit échangeur (12) de chaleur et ledit moyen formant soufflante (29).

10. Dispositif selon la revendication 7, dans lequel les ailettes de rayonnement (22) sont disposées sur les faces supérieure et inférieure ou sur les faces supérieure et latérales de ladite enceinte.
